# EUROPÄISCHE PATENTSCHRIFT

(11) **EP 1 544 320 B1**
(45) Veröffentlichungstag und Bekanntmachung des Hinweises auf die Patenterteilung: **14.10.2009**
(21) Anmeldenummer: 04029929.9
(22) Anmeldetag: 17.12.2004
(51) Int. Cl.: C23C 16/50, C23C 16/02, H05K 3/28

(54) **Verfahren zur Herstellung von Bauteilen mit passivierten Endoberflächen**
Process for manufacture of components with passivated end surfaces
Procédé de production de composants avec surfaces terminales passivées

(30) Priorität: 18.12.2003 DE 10359371
(43) Veröffentlichungstag der Anmeldung: 22.06.2005
(73) Patentinhaber: Fraunhofer-Gesellschaft zur Förderung der angewandten Forschung e.V., 80686 München (DE)
(72) Erfinder: Hegemann, Dirk, Dr., 70199 Stuttgart (DE); Oehr, Christian, Dr., 71083 Herrenberg (DE); Müller, Michaela, Dr., 70563 Stuttgart (DE)

(56) Entgegenhaltungen:
- EP-A2- 0 427 020
- US-A- 6 092 714

## Beschreibung

Die Erfindung betrifft ein Verfahren zur Herstellung eines Bauteils mit einer passivierten und lötfähigen Endoberfläche im Plasma sowie ein Bauteil mit einer passivierten Endoberfläche erhältlich durch dieses Verfahren.

In der Mikroelektronik werden die meisten elektronischen Bauelemente durch Löten auf dem die Bauelemente tragenden Bauteil, insbesondere einer Leiterplatte befestigt. Die dabei eingesetzten Lötverbindungen müssen den wachsenden Anforderungen wie dem umweltgerechten bleifreien "Packaging" sowie erhöhten thermischen oder mechanischen Belastungen, zum Beispiel im Automobilbereich, gerecht werden. Entscheidend für die Zuverlässigkeit einer elektronischen Baugruppe ist vor allem, dass die Lötverbindungen in der elektronischen Baugruppe eine ausreichend hohe Scherfestigkeit aufweisen. Der Lötprozess stellt somit einen wichtigen und gleichzeitig hoch anspruchsvollen Schritt bei der Herstellung elektronischer Baugruppen dar.

Ein Kriterium für die Eignung einer Oberfläche für die Verlötung ist auch ihre Benetzbarkeit. Zuverlässige Lötverbindungen können nur erhalten werden, wenn die Oberfläche vom Lot gut benetzt werden kann. Bevor eine Oberfläche verlötet werden kann, wird sie in der Regel einer Vorbehandlung unterzogen. Das am häufigsten verwendete Verfahren zur Vorbehandlung und Vorbereitung von Leiterplatten für das Verlöten ist das Hot-Air-Levelling-Verfahren (HAL). Dabei werden die Leiterplatten mit einer Schicht aus Zinn/Blei versehen, die eine gut lötfähige Endoberfläche darstellt. Als bleifreie Alternativen dazu kommen Schichten aus chemisch Nickel/Gold, chemisch Zinn oder auch organische Schutzschichten auf den Kupferoberflächen der Leiterbahnen in Frage. Die bekannten organischen Passivierungsschichten werden nasschemisch hergestellt.

Vor der Beschichtung einer zur Verlötung vorgesehenen Oberfläche, beispielsweise auf einer Leiterbahn, mit einer Passivierungsschicht oder Schutzschicht muss die Oberfläche zunächst von störenden Verschmutzungen, insbesondere von Oxidationsrückständen befreit werden. Dieser Vorgang wird als Entoxidation bezeichnet. Die den Lötvorgang störenden Rückstände, insbesondere Beläge auf der Oberfläche, können sowohl organische als auch anorganische Schichten sein und aus durch Oxidation gebildeten kohlenstoffhaltigen Verbindungen sowie aus Metalloxiden oder Metallhydriden bestehen, aber auch beispielsweise Klebe- und Polymerisationsrückstände aus der Leiterplattenfertigung sein. Diese Beläge stören das Kontaktieren mit Lötpasten, Lötzinn oder Passivierungsmitteln.

Die Entoxidation der Oberfläche einer beispielsweise kupferhaltigen Leiterbahn besteht insbesondere in der Reduktion des auf der Kupferoberfläche abgelagerten Kupferoxids zu elementarem Kupfer. Es sind Badreinigungsverfahren wie eine chemische Reinigung unter Einsatz eines chemischen Reinigungs- und/oder Aktivierungsmittels, das beispielsweise ein fluorierter chlorierter Kohlenwasserstoff, chlorierter Kohlenwasserstoff, eine andere Kohlenwasserstoffverbindung, ein herkömmliches Flussmittel oder eine wässrige Lösung eines reaktiven Stoffes sein kann, bekannt. Dabei können auch schwermetallhaltige Abfalllösungen anfallen. Diese Verfahren sind daher wegen der damit verbundenen Umweltbelastung jedoch wenig wünschenswert.

Zur Passivierung der zu verlötenden Oberflächen, insbesondere nachdem diese zuvor entoxidiert wurden, sind im Wesentlichen Verfahren bekannt, die Beschichtungen aus bevorzugt silberhaltigen Zusammensetzungen auf den Lötoberflächen von Bauteilen erzeugen, welche die gereinigten und entoxidierten Lötoberflächen vor erneuter Verschmutzung schützen, die Bildung von nicht lötfähigen Belägen, insbesondere von Kupferoxid auf den Kupferoberflächen verhindern und so eine gute Verlötbarkeit der Bauteile, hauptsächlich Leiterplatten gewährleisten. Die Anbringung einer Schutzschicht erfolgt zweckmäßigerweise unmittelbar nach der Reinigung und Entoxidation der Lötoberfläche und vor der Bestückung der Leiterplatten mit den elektronischen Bauelementen und deren Verlötung. Es kann jedoch eine erhebliche Zeitverzögerung zwischen der Bereitstellung der Leiterplatten und ihrer Bestückung und Verlötung bestehen. Es sind daher Bauteile wünschenswert, die auf der zu verlötenden Endoberfläche eine Schutzschicht aufweisen, die die Lötfähigkeit der Endoberfläche, das heißt ihren gereinigten und entoxidierten Zustand, über einen langen Zeitraum erhält und gleichzeitig die Lötbarkeit dieser Endoberfläche unterstützt.

Das Hot-Air-Levelling-Verfahren (HAL), bei dem auf den zu verlötenden Oberflächen eine Schicht aus einem eutektischen Gemisch aus Zinn und Blei aufgetragen wird, ist das am häufigsten angewandte Mittel zur Schutzbeschichtung. Es besitzt jedoch wesentliche Einschränkungen in seiner Anwendbarkeit. So ist es zum Beispiel nicht möglich, die Beschichtung in einer gleichmäßigen Dicke aufzubringen. Bei unterschiedlichen Beschichtungsstärken ist aber eine zuverlässige Lötbefestigung, insbesondere der heute verwendeten, sehr kleinen und nahe beieinander liegenden elektronischen Bauelemente wie der "surface-mount-devices" (SMD) erschwert und die Zuverlässigkeit der elektrischen Verbindung nicht mehr gewährleistet.

Dazu alternative Verfahren sind beispielsweise Passivierungen, die auf dem Einsatz von Imidazolen oder Triazolen basieren, wobei Kupferkomplexverbindungen nasschemisch auf der zu passivierenden Kupferoberfläche gebildet werden. Diese Beschichtungen gehen eine chemische Verbindung mit der Oberfläche ein und verhindern damit die Reaktion des Kupfers der Leiteroberfläche mit dem Luftsauerstoff und/oder anderen oxidierenden Agenzien. In dem nachfolgenden Lötschritt wird diese Passivierungsschicht durch die hohen Temperaturen des Lötvorgangs wieder zerstört, so dass das Lot nun die Kupferoberfläche benetzen kann. Ein Beispiel eines derartigen Verfahrens wird in EP 0 428 383 A dargestellt, wobei die kupferhaltige Kontaktfläche mit einer wässrigen Lösung aus einer Alkylbenzimidazolverbindung und einer organischen Säure benetzt wird. Organische Passivierungsschichten können eine entoxidierte Oberfläche vor der erneuten Oxidation bei Lagerung an Luft schützen. Die heute eingesetzten organischen Passivierungsschichten auf Kupferoberflächen weisen dabei eine Schichtdicke von 0,2 bis 0,5 µm auf. Dünnere Schichten werden aufgrund der nasschemischen Erzeugung ungleichmäßig und können somit die Lötbarkeit des Kupfers nicht mehr garantieren. Während des Lötprozesses sind daher immer Flussmittel oder ähnlich wirkende Agenzien erforderlich, um die relativ dicke Passivierungsschicht wieder entfernen zu können, da sonst eine Verlötung nicht möglich ist.

Weitere nasschemische Beschichtungsverfahren sind beispielsweise die Verfahren der nicht-galvanischen Silberplattierung basierend entweder auf Ammoniak, Thiosulfat oder auf Zyanidverbindungen: Ammoniakverfahren haben den Nachteil, dass die ammoniakhaltigen Silberlösungen instabil sind und sich leicht explosive Azide bilden können. Bei Thiosulfatverfahren stellt es sich als nachteilig für den Einsatz in der Elektronikindustrie heraus, dass Schwefelverbindungen, die sich bei der Silberbeschichtung bilden, zu einer Verschlechterung der Lötfähigkeit führen. In der US 5,318,621 A wird beispielsweise eine Lösung zur Beschichtung von zu verlötenden Oberflächen beschrieben, die Aminosäuren zur Beschleunigung des Niederschlags von Silber beziehungsweise Gold auf einer zuvor mit Nickel beschichteten Kupferoberfläche enthält. Die Vorbeschichtung der kupferhaltigen Endoberfläche mit Nickel ist notwendig, da sich nicht-galvanische Beschichtungsbäder, die auf Thiosulfat basieren, nicht für die Auflage von Gold beziehungsweise von Silber auf Kupfer eignen, da sich das Kupfer in diesen Lösungen schnell auflöst, bevor eine Gold- beziehungsweise Silberschicht darauf gebildet werden kann.

Die US 4,863,766 beschreibt ebenfalls eine nicht-galvanische Silberplattierung unter Verwendung einer Plattierungslösung auf Zyanidbasis. Diese Plattierungslösung besitzt allerdings eine hohe Toxizität; Zyanidverfahren sind daher ebenfalls nachteilig.

Die JP 0 411 047 A beschreibt eine Silberbeschichtung eines Kontaktmaterials, die nach Trocknung mit einer Mercaptanverbindung gegen Anlaufen geschützt wird.

Die DE 695 11 434 T2 beziehungsweise EP 0 797 690 B1 beschreibt ein Verfahren zum Beschichten einer gedruckten Leiterplatte, wobei der Metallbeschichtungsschritt durch eine Immersion/Umlagerung erfolgt. Dabei werden die zu beschichtenden Metalloberflächen mit einer wässrigen Lösung zusammengebracht, die lonen eines Metalls in einer Form enthält, in der sie stärker elektropositiv sind als das zu beschichtende Metall. Dies wird vorzugsweise durch einen mehrzähnigen komplexbildenden Ligandenwirkstoff erreicht. Auf diese Weise können Silber-, Wismut-, Zinn-, Palladium- und/oder Goldschichten erzeugt werden.

Die DE 4 316 679 C1 beschreibt ein Beschichtungsverfahren in zwei Schritten zum Aufbringen von Palladium auf Lötoberflächen aus beispielsweise Kupfer. Dabei werden die zu beschichtenden Oberflächen jeweils mit einem Bad in Berührung gebracht, das in einem ersten Schritt ein Palladiumsalz und einen oxidierenden Wirkstoff und in einem zweiten Schritt ein Palladiumsalz, einen komplexbildenden Wirkstoff sowie Ameisensäure oder ein Ameisensäurederivat enthält.

In der DE 4 226 167 C2 werden Goldkontakte beschrieben, die insbesondere als Gold-Höcker oder Gold-Flächen aus einem sulfitischen Goldbad mit einem Kornverfeinerer und in einer sehr geringen Abscheidungsgeschwindigkeit auf einer Kontaktoberfläche abgeschieden werden.

Alle die vorgenannten Verfahren stellen Mehr-Schritt-Verfahren dar, da jeweils das Basismetall des Leiters, überwiegend Kupfer, zunächst in einem einem Ätzschritt entsprechenden Arbeitsschritt, zum Beispiel dem Glanzätzen, gefolgt von einem einem Nachspülschritt entsprechenden Arbeitsschritt gereinigt wird und anschließend in weiteren Arbeitsschritten die Schutzbeschichtung, insbesondere die Passivierungsschicht aufgebracht wird. Außerdem sind die vorgenannten Verfahren jeweils nasschemische Verfahren, die durch Verwendung von Lösemitteln und metallionenhaltigen Abfalllösungen die Umwelt stark belasten.

In der Plasmatechnik ist die Abscheidung von Schichten, die passivierende Eigenschaften besitzen, bekannt. Durch eine hohe Vernetzung der Schichten während ihrer Abscheidung aus kohlenwasserstoffhaltigen Gasen werden dichte organische Schichten erzeugt, die eine deutlich reduzierte Gas- und/oder Wasserdurchlässigkeit aufweisen und als Korrosionsschutz- oder Barriereschichten eingesetzt werden können. Darüber hinaus können auch diamantähnliche Schichten ("diamond-like-coating", DLC) in verschiedenen Plasmaverfahren abgeschieden werden.

Die DE 197 17 698 A1 beschreibt ein Verfahren zur Reinigung und Aktivierung von elektrischen Leiterbahnen und Platinenoberflächen mittels einer dielektrisch behinderten Gasentladung bei Normaldruck oder erhöhten Drücken (10 mbar bis 10 bar), wobei oxidierende und/oder reduzierende Gase eingesetzt werden. Durch die Anwendung dieses Verfahrens kann außerdem auf Flussmittel beim Lötprozess verzichtet werden. Da bei diesem Verfahren eine Schutzbeschichtung zur Verhinderung einer Wiederverschmutzung der Leiteroberflächen nicht vorgesehen ist, und auch unter den gewählten Bedingungen der dielektrisch behinderten Entladung nicht zu erwarten ist, muss das Verfahren zur Verhinderung erneuter Oxidation der gereinigten und oxidationsempfindlichen Oberflächen in den Fertigungsprozess von elektronischen Baugruppen integriert und praktisch erst unmittelbar vor dem Lötprozess durchgeführt werden.

Die DE 689 11 953 T2 beziehungsweise EP 0 330 211 B1 beschreibt Passivierungsschichten für Supraleiter. Dabei handelt es sich um polymerisierte organische Passivierungsschichten auf der Basis plasmaabgeschiedener Fluorkohlenstoffschichten. Der plasmapolymerisierte Film, der auf der Fläche des Supraleiters gebildet wird, umfasst insbesondere die Fluorradikale CF₂ und CF₃. Die Beschichtung des Supraleiters erfolgt in einer Plasmaentladung eines organischen, gasförmigen Fluorkohlenwasserstoffs bei einem Druck zwischen 10 und 200 Pa.

Plasmaschichten aus Kohlenwasserstoffen zum Einsatz in der Elektronikindustrie werden zum Beispiel in der DE 694 05 002 T2 beziehungsweise EP 0 720 665 B1 beschrieben. Dabei werden diamantähnliche Schichten (DLC) aus einem Wasserstoff/Methan-Gemisch abgeschieden. Diese sind allerdings nicht als Passivierungsschichten vorgesehen, die bis zum Zeitpunkt der Verlötung auf der Oberfläche verbleiben. Sie weisen darüber hinaus keinerlei Haftung zu Kupfer auf.

Die JP 601 36 339 erwähnt eine plasmaabgeschiedene Passivierungsschicht innerhalb eines lötfähigen Elektrodenaufbaus. Diese dient allerdings nicht als Schutzbeschichtung für die Verlötung.

Die US 6 092 714 offenbart ein Verfahren zum Reinigen und Beschichten eines leitenden Bauteils mit einem Plasmagas, das Argon und CF₄ enthält.

Gemeinhin wird davon ausgegangen, dass um Lötbarkeit zu garantieren, eine saubere Oberfläche erzeugt werden muss. Eine sehr saubere und möglicherweise noch reduzierte Oberfläche ist, wie auch vorstehend dargestellt, sehr oxidationsempfindlich, das heißt sehr reaktiv. Dieser Nachteil ist zunächst unbeachtlich und eventuell wünschenswert, falls unmittelbar nach der Behandlung verlötet wird. Jedoch besteht der Wunsch nach dauerhaft lötbaren Oberflächen. Meist ist weder ein sofortiges Löten nach der Reinigung immer garantiert, noch kann der Kontakt der Oberfläche mit der (oxidierenden) Atmosphäre dauerhaft ausgeschlossen werden.

Zwar können, wie oben erwähnt, mittels der Plasmatechnik Schutzschichten aus Gasen abgeschieden werden, welche nur wenige Nanometer dick sind; eine gleichmäßige Beschichtung der Endoberflächen würde dadurch möglich, so dass auch sehr kleine und nahe nebeneinander liegende Bauelemente verlötet werden könnten. Allerdings dienen die bekannten mittels Plasmaverfahren abgeschiedenen Passivierungsschichten der permanenten Passivierung. Die Entfernung dieser permanenten Passivierungsschichten während des Lötprozesses ist in der Regel nicht möglich oder nur sehr unkontrolliert möglich. Ohne die Möglichkeit einer vollständigen und kontrollierten Entfernung der Passivierungsschicht vor oder während des Lötvorgangs kann keine oder keine mechanisch oder elektrisch stabile Lötverbindung hergestellt werden. Daher sind die bekannten mittels Plasmaverfahren generierten Passivierungsschichten nicht für die Passivierung von für die Verlötung vorgesehenen Oberflächen geeignet.

Aus dem Stand der Technik ist kein Verfahren bekannt, das die Reinigung, das heißt Entoxidation, und Passivierung einer zur Verlötung vorgesehenen Oberfläche eines Bauteils in einem einzigen Verfahrensschritt mittels eines Plasmaverfahrens beschreibt. Auch ist kein Bauteil mit einer passivierten Endoberfläche bekannt, wobei insbesondere die Passivierungsschicht bis zur Weiterverarbeitung des Bauteils mit der passivierten Endoberfläche in einem anderen Fertigungsschritt und zu einem späteren Zeitpunkt bestehen bleibt und die Passivierungsschicht gleichzeitig die Verlötung unterstützt.

Darüber hinaus beruhen die heute gängigen Verfahren zum Verlöten von Bauelementen insbesondere in elektronischen Baugruppen im Wesentlichen auf der Verwendung von bleihaltigen Loten und Flussmitteln. Ab dem 1. Januar 2006 ist die Verwendung von Blei für elektronische Bauelemente und Baugruppen nicht mehr zugelassen. Dies erfordert die Verwendung von bleifreien Ersatzloten und neue und hohe Anforderungen an die zu verlötende Endoberfläche, insbesondere an die Passivierung der Endoberfläche. Das vorgenannte Hot-Air-Levelling (HAL), worin ein Zinn/Blei-Lötmittel die zu verlötende Oberfläche bildet, ist wegen des Verbots der Verwendung von Blei nicht mehr einsetzbar.

Das der vorliegenden Erfindung zugrunde liegende technische Problem, das heißt der Ausgangspunkt der Erfindung, besteht demgemäß im Wesentlichen darin, Bauteile, insbesondere für den Einsatz in elektronischen Baugruppen bereitzustellen, die eine verbesserte Passivierungsschicht auf ihrer verlötbaren Endoberfläche aufweisen, sowie ein verbessertes Verfahren zum Erhalt von Bauteilen mit einer verbesserten passivierten Endoberfläche bereitzustellen.

Die vorliegende Erfindung löst dieses technische Problem durch ein Verfahren gemäß Anspruch 1 zur Herstellung eines Bauteils mit einer passivierten und lötfähigen Endoberfläche, wobei in einem einzigen Verfahrensschritt die zur Verlötung vorgesehene Oberfläche des Bauteils durch Entoxidation gereinigt und eine Passivierungsschicht auf der Oberfläche des Bauteils abgelagert, das heißt abgeschieden wird, wodurch ein Bauteil mit einer passivierten und lötfähigen Endoberfläche erhalten wird.

Insbesondere löst die vorliegende Erfindung das ihr zugrundeliegende technische Problem durch die Bereitstellung eines Verfahrens zur Herstellung eines Bauteils mit einer passivierten und lötfähigen Endoberfläche, wobei ein zu verlötendes Bauteil mit einer Endoberfläche, welche insbesondere aus Metall besteht oder dieses in wesentlichen Anteilen, zum Beispiel mehr als 50 %, 60 %, 70 %; 80 %, 90 %, 90 % oder 95 %, insbesondere 97 % (Gew.-%) enthält, bereitgestellt wird und in einem einzigen Verfahrensschritt die zur Verlötung vorgesehene Endoberfläche des Bauteils durch Entoxidation gereinigt und eine Passivierungsschicht auf der Oberfläche des Bauteils, insbesondere der Endoberfläche abgelagert, das heißt abgeschieden wird, wodurch ein Bauteil mit einer passivierten und lötfähigen Endoberfläche erhalten wird, welches anschließend, optimal, einem Lötverfahren zugeführt werden kann, insbesondere einem Lötverfahren im Rahmen dessen die aufgebrachte Passivierungsschicht während des Lötens entfernt, insbesondere thermisch entfernt werden kann.

Erfindungsgemäß ist vorgesehen, dass die auf der Endoberfläche des erfindungsgemäß hergestellten Bauteils aufgetragene Passivierungsschicht durch thermische Einwirkung, insbesondere durch thermische Einwirkung während des Lötprozesses, von der Endoberfläche des Bauteils wieder entfernbar sein kann.

Durch das erfindungsgemäße Verfahren wird ein Bauteil mit einer Endoberfläche erhalten, die eine Passivierungsschicht aufweist, die besonders dauerhaft ist und die entoxidierte, gereinigte Endoberfläche über einen langen Zeitraum vor Verunreinigungen und Oxidation schützt. So kann der Fertigungsprozess elektronischer Baugruppen beispielsweise zwischen der Leiterplattenherstellung und der Bestückung der Leiterplatten und Verlötung mit den elektronischen Bauelementen über einen längeren Zeitraum unterbrochen werden, ohne dass es zu einer erneuten Verunreinigung oder Oxidation der zu verlötenden gereinigten und entoxidierten Endoberflächen kommt. Demgemäß besteht die Funktion der auf der Endoberfläche des erfindungsgemäß hergestellten Bauteils abgeschiedenen Passivierungsschicht insbesondere darin, eine Oxidation entlang der Grenzfläche der Endoberfläche zu verhindern.

Es wurde überraschenderweise gefunden, dass die in dem erfindungsgemäßen Herstellverfahren auf der Endoberfläche des Bauteils abgeschiedene Passivierungsschicht außerdem bei Temperaturen von mindestens 100°C, also insbesondere während der Verlötung, vollständig abgelöst wird. Das heißt, die zu verlötende Endoberfläche des Bauteils wird von der sie schützenden Passivierungsschicht erst im Augenblick der Verlötung rückstandslos befreit, so dass keine Gelegenheit zur Oxidation oder Verunreinigung dieser Oberfläche vor dem Lötprozess besteht. Durch die erfindungsgemäß erzeugte Passivierungsschicht wird demgemäß die Verlötung der Endoberfläche optimal unterstützt, da die Passivierungsschicht während des Lötvorgangs vollständig entfernt wird, und außerdem die Endoberfläche zu keinem Zeitpunkt vor der Verlötung gegen Oxidation und Wiederverschmutzung ungeschützt ist. Daher wird mit dem erfindungsgemäßen Herstellverfahren ein Bauteil erhalten, das eine passivierte Endoberfläche aufweist, das gleichzeitig lötbar ist.

Während der Fachmann stets bemüht ist, die Oberfläche sauber, das heißt frei von Ablagerungen und Schichten, zu halten, und er daher bisher im Wesentlichen nur mit nicht schichtbildenden Plasmen wie Argon, Sauerstoff, Wasserstoff und Stickstoff arbeitete, wird erfindungsgemäß mit der Reinigung, insbesondere gleichzeitig in einem Schritt, eine Schicht gebildet, welche die aktive Metalloberfläche schützt, weil sie dünn aber trotzdem geschlossen ist, hingegen den Lötprozess nicht behindert, weil sie gegen die Lötbedingungen thermisch nicht stabil ist.

Im Gegensatz zu den bisher bekannten Verfahren können so erfindungsgemäß Leiteroberflächen elektronischer Baugruppen erhalten werden, die in einem einzigen Verfahrensschritt entoxidiert und passiviert werden. Bei den erfindungsgemäß erhaltenen Bauteilen kann zur Entfernung der Passivierungsschicht der passivierten Endoberflächen unmittelbar vor der Verlötung auf zusätzliche Verfahrensschritte vollständig verzichtet werden. Mit dem erfindungsgemäßen Verfahren werden Bauteile, insbesondere Leiterplatten erhalten, die einfach und kostengünstig gereinigt und gleichzeitig dauerhaft gegen erneute Oxidation und Verschmutzung der Endoberflächen geschützt sind. Die so erhaltenen Bauteile können in beliebigen bekannten Lötverfahren eingesetzt werden.

Im Zusammenhang mit der vorliegenden Erfindung wird unter einem "Bauteil" jeder Gegenstand mit einer zur Verlötung vorgesehenen Oberfläche verstanden. Dieses Bauteil kann Bestandteil einer elektronischen Baugruppe sein, beispielsweise eine Leiterplatte mit Leiterbahnen, ein Kontaktelement, Verbindungselement, Steckverbinder, Schaltelement oder ein aktives oder passives elektronisches Bauelement, wobei die zur Verlötung vorgesehene Oberfläche insbesondere aus einem für die elektrische Kontaktierung geeigneten Metall wie Kupfer oder einer Metalllegierung besteht. Die Verlötung der zur Verlötung vorgesehenen Oberfläche dieses Bauteils dient der mechanischen Befestigung und/oder elektrischen Kontaktierung des Bauteils mit weiteren Bauteilen zum Beispiel innerhalb einer elektronischen Baugruppe und/oder eines mechanischen Aufbaus.

Im Zusammenhang mit der vorliegenden Erfindung wird unter einer "Endoberfläche" eine behandelte und zur Verlötung vorgesehene Oberfläche eines Bauteils, beispielsweise die Oberfläche einer kupferhaltigen Leiterbahn auf einer Leiterplatte, verstanden, die direkt und ohne weitere Arbeitsschritte verlötet werden kann. Die Endoberfläche stellt bevorzugt die Stelle auf einer Leiterplatte dar, mit der die elektrischen oder elektronischen Bauelemente durch den Lötvorgang mechanisch und elektrisch mit der Leiterplatte verbunden werden. Eine zur Verlötung vorgesehene Endoberfläche kann aber auch auf anderen zu verlötenden Bauteilen vorliegen.

Im Zusammenhang mit der vorliegenden Erfindung wird unter "entoxidieren" oder Entoxidation" ein Vorgang zur Reinigung einer zur Verlötung vorgesehenen Oberfläche verstanden, insbesondere die Befreiung von den Lötvorgang störenden und die mechanische und elektrische Stabilität der Verlötung beeinträchtigenden Verschmutzungen und Belägen auf der Oberfläche, hauptsächlich von durch Oxidation gebildeten kohlenstoffhaltigen Verbindungen, Metalloxiden, meist Kupferoxid, oder Metallhydriden, aber auch von Rückständen aus der Leiterplattenfertigung. Die Entoxidation der Oberfläche einer beispielsweise kupferhaltigen Leiterbahn besteht speziell in der Reduktion des auf der Kupferoberfläche abgelagerten Kupferoxids zu elementarem Kupfer.

Im Zusammenhang mit der Vorliegenden Erfindung wird unter "Passivierung" oder "passiviert" ein Zustand beschrieben, bei dem eine Grenzfläche eines Metalls, insbesondere die zur Verlötung vorgesehene Oberfläche einer beispielsweise kupferhaltigen Leiterbahn, nicht oder nur in unwesentlichem Maße mit dem sie umgebenden Medium, hauptsächlich Luftsauerstoff oder oxidierenden Agenzien in Wechselwirkung treten kann, da die Grenzfläche ein chemisch stark verringertes Reaktionsvermögen aufweist. Im Wesentlichen weisen passivierte Metalloberflächen eine schützende zusammenhängende Oberflächenschicht (= "Passivierungsschicht") auf, die aus einer auf der Oberfläche abgeschiedenen Schicht besteht, die die Wechselwirkung des Metalls mit dem Medium verhindert oder wesentlich unterdrückt. Im Zusammenhang mit der vorliegenden Erfindung wird unter "Passivierungsschicht" also eine Deck- oder Schutzschicht auf der Oberfläche eines Metalls verstanden.

Im Zusammenhang mit der vorliegenden Erfindung wird unter "lötfähig" ein Zustand beschrieben, bei dem eine zur Verlötung vorgesehene Oberfläche oder Endoberfläche direkt und ohne Zwischenschaltung weiterer Vorbehandlungsschritte der Verlötung zugänglich ist. insbesondere sind bei einer lötfähigen Endoberfläche die für die Verlötung relevanten Parameter wie Lot-Benetzungsfähigkeit, Benetzungsrandwinkel besonders günstig. Auf einer lötfähigen Endoberfläche sind die mechanische und elektrische Stabilität der Verlötung störende Beläge abwesend.

Im Zusammenhang mit der vorliegenden Erfindung wird unter einem "einzigen Verfahrensschritt" ein Vorgang verstanden, der durch die Durchführung eines unabhängigen und nicht weiter unterteilbaren Arbeitsschritts gekennzeichnet ist: Die bereitgestellten Eingangselemente (Edukte) des Herstellverfahrens werden in einem "einzigen Verfahrensschritt" in die Produkte umgewandelt, ohne dass dabei eine Möglichkeit zur äußeren Einflussnahme auf den Verfahrensschritt gegeben ist. Der "einzige Verfahrensschritt" läuft also stereotyp ab. Dass dabei mehrere, hauptsächlich chemische und physikalische Prozesse parallel oder in Folge ablaufen, ist vorgesehen; diese sind aber nicht voneinander unabhängig und trennbar und bilden erst in ihrer Gesamtheit den "einzigen Verfahrensschritt". Allein die zeitliche Ausdehnung der Abfolge der einzelnen chemischen und physikalischen Prozesse lässt sich von "außen" für den "einzige Verfahrensschritt" festlegen, nicht aber die Reihenfolge und Ordnung dieser Einzelprozesse. Insbesondere gehen die Einzelprozesse kontinuierlich ineinander über.

Wie oben erwähnt, beeinträchtigen vor allem Oxidschichten eine gute Benetzung der Lote beim Verlöten unter erhöhten Temperaturen, weshalb bisher immer noch Flussmittel, die chemisch aggressive Stoffe enthalten (zum Beispiel reduzierende Agenzien wie Säuren), beim Lötprozess erforderlich sind, um elektrisch gut leitende und stabile Lötverbindungen zu erhalten.

Dem gegenüber bietet die Plasmatechnik den Vorteil, Metalloberflächen sehr gut reinigen zu können. Die Entoxidation von Metalloberflächen mittels Plasmatechnik unter Verwendung von reduzierenden beziehungsweise abtragenden Gasen wurde bereits untersucht. Dabei zeigte sich, dass die Möglichkeit der Entoxidation von den freien Energien der Oxidation der Metalle abhängt und dass demnach Kupfer, Nickel und Eisen gut entoxidiert werden können.

In einer besonders bevorzugten Ausführungsform des vorgenannten Verfahrens wird zur Entoxidation der Endoberfläche ein überwiegend reduzierendes Plasmagas eingesetzt. Insbesondere ist dieses überwiegend reduzierende Plasmagas Argon (Ar), Wasserstoff (H₂) oder eine Mischung aus Argon und Wasserstoff (Ar/H₂). Die Entoxidation mit einem wasserstoffhaltigen Plasma bietet den Vorteil, dass neben der Reduktion aufliegender Metalloxide (zum Beispiel CuO₂) zum elementaren Metall die Oberfläche des Bauteils auch von kohlenstoffhaltigen wie organischen Verunreinigungen gereinigt wird, die dabei hauptsächlich in kurzkettige Kohlenwasserstoffe gespalten werden und in die Gasphase übergehen. Zudem wird dadurch die entoxidierte Metalloberfläche im Plasma derart aktiviert, dass sich eine hohlraumfreie Anbindung der nachfolgend aufgetragenen kohlenwasserstoffhaltigen Passivierungsschicht ergibt. Die erfindungsgemäße Abscheidung der Passivierungsschicht auf dem Bauteil unmittelbar nach der Entoxidation und der Aktivierung der Metalloberfläche in einem reduzierenden Plasmagas stellt ein Bauteil mit einer passivierte Endoberfläche bereit, die besonders effektiv gegen Oxidation geschützt ist. Besonders bevorzugt gehen dabei die Prozesse der Entoxidation und der Abscheidung der Passivierungsschicht in dem erfindungsgemäßen einzigen Verfahrensschritt kontinuierlich ineinander über.

Das erfindungsgemäße Verfahren lässt sich aber auch anwenden, nachdem die Lötoberflächen auf anderem Wege gereinigt und/oder entoxidiert wurden, wobei die Dauer der Entoxidation im Plasma im erfindungsgemäßen Verfahren verkürzt werden kann.

Erfindungsgemäß erfolgt die Passivierung der Endoberfläche mit einem kohlenwasserstoffhaltigen Monomergas. Insbesondere ist dieses kohlenwasserstoffhaltige Monomergas reines Methan, das wahlweise mit oder ohne Trägergas eingesetzt wird. Aus diesen kohlenwasserstoffhaltigen Monomeren können abhängig vom Leistungseintrag polymer- bis diamantähnliche Schichten abgeschieden werden. Entscheidend ist dabei, dass die Schichten hinreichend vernetzt sind, um einen guten Oxidationsschutz zu gewährleisten, aber auch keine zu hohe Stabilität und Haftung aufweisen, um während des Lötprozesses bevorzugt durch thermische Einwirkung wieder entfernt werden zu können. Die Erfinder fanden besonders überraschend, dass dazu die Verwendung von Methan als schichtbildendes Monomergas besonders vorteilhaft ist, da bei dessen Verwendung ein hoher Anteil an Wasserstoff in den gebildeten Polymerschichten verbleibt, wodurch ihre thermische Beständigkeit beeinträchtigt ist, ein ausreichender Passivierungsschutz jedoch gegeben ist. Durch die erfindungsgemäß bevorzugte Wahl von Methan zur Erzeugung der Passivierungsschicht wird also im erfindungsgemäßen Verfahren auf der Endoberfläche eine Passivierungsschicht abgeschieden, die thermisch weniger stabil ist als bisher bekannte Passivierungsschichten und deshalb insbesondere durch die thermische Einwirkung beim Lötvorgang wieder abgetragen werden kann.

In einer bevorzugten Variante des erfindungsgemäßen Verfahrens werden definierte Verfahrensparameter, insbesondere definierte Plasmaverfahren, definierte Gasflüsse, definierte Substrattemperaturen, definierte Behandlungsdauern, eine definierte Leistungsdichte/Fläche, eine definierte Leistungsdichte/Entladungsvolumen und eine definierte Anregungsfrequenz eingesetzt.

In einer bevorzugten Ausführungsform des erfindungsgemäßen Verfahrens wird die Passivierungsschicht auf der Endoberfläche mit einem Niederdruckplasma abgeschieden. Dabei werden bevorzugt Drücke zwischen 0,1 und 5 mbar eingesetzt. Das Niederdruckplasmaverfahren ist besonders geeignet, da mit diesem dünne Schichten mit definierter Zusammensetzung auf großen Flächen und auch auf geformten Bauteilen abgeschieden werden können.

In einer weiteren bevorzugten Ausführungsform werden Gasflüsse von 1 bis 200 Standardcubikcentimeter pro Minute (sccm), vorzugsweise in Reaktionsräumen kleiner als 20 Liter verwendet.

Erfindungsgemäß bevorzugt beträgt die Temperatur des Substrates, das heißt des Bauteils von 0° C bis 100° C, insbesondere von 15°C bis 30° C, vorzugsweise Raumtemperatur.

Eine erfindungsgemäß bevorzugte Behandlungsdauer unter Einsatz des erfindungsgemäßen Verfahrens beträgt 2 min bis 30 min, insbesondere 5 min.

In einer erfindungsgemäß bevorzugten Ausführung wird im Rahmen des erfindungsgemäßen Verfahrens eine Leistungsdichte/Fläche von 0,01 bis 0,25 W/cm², insbesondere 0,1 W/cm², verwandt.

In einer weiteren erfindungsgemäß bevorzugten Ausführung wird im Rahmen des erfindungsgemäßen Verfahrens eine Leistungsdichte/Entladungsvolumen von 0,001 bis 0,03 W/cm³, insbesondere 0,01 W/cm³, verwandt.

Erfindungsgemäß bevorzugt wird im Rahmen des erfindungsgemäßen Verfahrens eine Anregungsfrequenz von 40 kHz bis 2,45 GHz, vorzugsweise von 1 MHz bis 50 MHz, insbesondere 13,56 MHz eingesetzt.

Erfindungsgemäß besitzt die mit dem erfindungsgemäßen Verfahren auf der Endoberfläche des Bauteils abgeschiedene Passivierungsschicht eine Schichtdicke von 15 bis 100 nm, bevorzugt von 15 bis 50 nm, besonders bevorzugt etwa 35 nm. Diese ultradünnen Schichten, die direkt im Anschluss an die Entoxidation im Plasma abgeschieden werden, sind in der Lage, die Oxidation der Endoberflächen, insbesondere der Kupferoberflächen von Leiterbahnen über längere Zeiträume zu unterdrücken. Unter thermischer Einwirkung zersetzen sie sich hingegen bei Temperaturen von mindestens 100°C.

Erfindungsgemäß bevorzugt weist die abgeschiedene Passivierungsschicht eine bestimmte Zusammensetzung aus Kohlenstoff, Wasserstoff und Sauerstoff auf, insbesondere eine, bei der die Zusammensetzung aus 0 bis 2 % Sauerstoff, aus 10 % bis 40 % Wasserstoff und aus 58 % bis 90 % Kohlenstoff besteht.

Erfindungsgemäß bevorzugt weist die mittels den erfindungsgemäßen Verfahren auf der Endoberfläche des Bauteils abgeschiedene Passivierungsschicht eine Haftung von cirka 1,5 bis 3,5 N/cm² mit der Endoberfläche auf. Dabei ist die gewählte Haftung erfindungsgemäß hoch genug, um eine Oxidation entlang der Grenzfläche zwischen der aufgetragenen Passivierungsschicht und der Endoberfläche des Bauteils zu verhindern, jedoch aber noch niedrig genug, so dass sie bei Temperaturen von mindestens 100°C von der Endoberfläche entfernbar ist.

In einer bevorzugten Variante des vorgenannten erfindungsgemäßen Verfahrens besteht die zu behandelnde Oberfläche des Bauteils aus Metall oder Metallen oder enthält diese in wesentlichen Anteilen. Vorzugsweise weist die zu behandelnde Oberfläche des Bauteils keine Halbleiter, Halbleiterbauelemente, Halbleitersubstrate oder Halbleitermaterialien auf.

Erfindungsgemäß bevorzugt kann die zu behandelnde Oberfläche des Bauteils Kupfer, Gold, Platin, Zink, Nickel, Eisen, Chrom, Titan, Silber, Blei und/oder Vanadium aufweisen, vorzugsweise aus einem oder mehreren davon bestehen oder in wesentlichen Anteilen enthalten.

Erfindungsgemäß bevorzugt wird die passivierte Endoberfläche zum Verlöten benutzt beziehungsweise stellt die Lötstelle eines Bauteils dar.

In einer bevorzugten Variante des vorgenannten erfindungsgemäßen Verfahrens besteht die zu behandelnde Oberfläche des Bauteils aus einer Leiteroberfläche aus Kupfer. Insbesondere ist dabei das Bauteil eine Leiterplatte beispielsweise einer elektronischen Baugruppe.

In einer weiteren Variante ist die zur Verlötung vorgesehene Oberfläche des Bauteils eine Kontaktfläche, beispielsweise eines Steckverbinders oder eines Schalters. Das erfindungsgemäße Bauteil kann die zur Verlötung vorgesehene Oberfläche ein Form einer Lötöse oder eines einer Lötöse in der Funktion vergleichbaren Elements aufweisen.

Ein weiterer Gegenstand der vorliegenden Anmeldung ist eine Bauteil mit einer passivierten und lötfähigen Endoberfläche, deren Passivierungsschicht eine Schichtdicke von 15 bis 100 nm aufweist und durch thermische Einwirkung entfernbar ist, und die durch das erfindungsgemäße Verfahren erhältlich ist.

In einer bevorzugten Variante besteht die passivierte und lötfähige Endoberfläche aus amorphen Kohlenwasserstoffschichten auf der behandelten Oberfläche, insbesondere auf Metallen, und nicht auf Halbleitern oder Isolatoren.

Lötversuche zeigen, dass die mit dem erfindungsgemäßen Verfahren erzeugten Bauteile passivierte und lötfähigen Endoberflächen aufweisen, die vollständig durch bleihaltige Lote benetzt werden. Dies ist ebenso der Fall bei der Verwendung bleifreier Lote mit Flussmittel und unter Schutzgasatmosphäre, wie dies zum Beispiel beim Reflow-Löten angewendet wird. Werden bleifreie Lote unter Schutzgas ohne Flussmittel eingesetzt, zeigt sich ebenfalls eine sehr gute Benetzung.

Die vorliegende Erfindung betrifft auch ein Verfahren zum Löten das heißt Verbinden von mindestens zwei Bauteilen, wobei mindestens eines dieser Bauteile ein erfindungsgemäß hergestelltes Bauteil ist, wobei das Verfahren dadurch ausgezeichnet ist, dass während des Lötprozesses die zuvor aufgebrachte Passivierungsschicht entfernt wird, insbesondere aufgrund thermischer Einwirkung entfernt wird.

Die Erfindung wird anhand der folgenden Ausführungsbeispiele näher erläutert, die jedoch nicht beschränkend zu verstehen sind:

### Beispiel 1:

Eine Kupferoberfläche eines Bauteils wird in einem mit 13,56 MHz angeregten Plasma für 30 Minuten mit Wasserstoff bei 300 W/cm², 50 sccm und 0,25 mbar entoxidiert. Direkt im Anschluss wird, ohne die vorgenannten Parameter zu verändern, als kohlenstoffhaltiges Monomergas Methan hinzugegeben und das Wasserstoffgas abgestellt. Innerhalb von 3,5 Minuten wird aus diesem reinen Monomergas-Plasma eine cirka 35 nm dicke, homogene Kohlenwasserstoffschicht abgeschieden.

### Ergebnisse:

1. Die erfindungsgemäß auf der Endoberfläche des Bauteils abgeschiedene Passivierungsschicht weist eine Sauerstoffdurchlässigkeit von 2,5 cm³/m² d bar und eine Wasserdampfdurchlässigkeit von 0,4 g/m² d auf. Dies wurde an damit beschichteten PET-Folien ermittelt.
2. Messungen mittels Augerelektronenspektroskopie zeigen, dass der Sauerstoffanteil in der Grenzfläche Kupfer/Passivierungsschicht deutlich reduziert ist; dieser steigt auch nach einem Monat nicht wieder merklich an.

### Beispiel 2:

### a) Lötfähigkeit

Zur Ermittlung der Lötfähigkeit der erfindungsgemäßen Bauteile mit passivierter Endoberfläche wurden Lötversuche mit bleifreien und bleihaltigen Loten unter verschiedenen Bedingungen durchgeführt.

Die Ergebnisse der Untersuchungen stellen sich wie folgt dar:

Die passivierten Endoberflächen der erfindungsgemäß erzeugten Bauteile werden durch bleihaltige Lote vollständig benetzt.

Bleifreie Lote mit Flussmittel unter Schutzgasatmosphäre (zum Beispiel Reflow-Löten) benetzen die passivierten Endoberflächen dieser Bauteile ebenfalls vollständig.

Bleifreie Lote ohne Flussmittel unter Schutzgas benetzen ebenfalls sehr gut. Der Randwinkel beträgt dabei zwischen Endoberfläche und flüssigem Lot etwa 20°.

Herkömmliche Bauteile mit gereinigte Kupferoberflächen ohne Passivierungsschicht (Vergleichsbeispiel) weisen dagegen bei gleichem Vorgehen einen Randwinkel von etwa 35° auf, was einer deutlich schlechteren Benetzung entspricht.

### b) Mechanische Stabilität

Zusätzlich durchgeführte Adhäsionskraftmessungen zeigen, dass die an der passivierten und lötfähigen Endoberfläche erfindungsgemäß hergestellter Leiterplatten erstellte Lötverbindung mechanisch stabiler ist als die mit dem Lot verbundene 18 µm starke Kupferfolie der Leiterplatte. Das bedeutet, die so erhaltene Lötverbindung ist außerordentlich stabil und weist auch eine für den Einsatz in elektronischen Baugruppen für erhöhte mechanische Anforderungen ausreichend hohe Scherfestigkeit auf.

## Patentansprüche

1. Verfahren zur Herstellung eines Bauteils mit einer passivierten und lötfähigen Endoberfläche, wobei in einem einzigen Verfahrensschritt die zur Verlötung vorgesehene Oberfläche des Bauteils durch Entoxidation gereinigt und eine Passivierungsschicht aus kohlenwasserstoffhaltigem Monomergas in einem Niederdruckplasma darauf abgeschieden wird, wobei die abgeschiedene Passivierungsschicht eine Schichtdicke von 15 bis 100 nm aufweist, und wobei die auf der passivierten Endoberfläche des Bauteils abgeschiedene Passivierungsschicht durch thermische Einwirkung von dieser wieder entfernbar ist, wodurch ein Bauteil mit einer passivierten und lötfähigen Endoberfläche erhalten wird.

2. Verfahren nach Anspruch 1, wobei die thermische Einwirkung ein Lötprozess ist.

3. Verfahren nach Anspruch 1 oder 2, wobei die Temperatur bei der thermischen Einwirkung mindestens 100°C beträgt.

4. Verfahren nach einem der vorangehenden Ansprüche, wobei die auf der passivierten Endoberfläche des Bauteils abgeschiedene Passivierungsschicht eine Schichtdicke von 15 bis 50 nm aufweist.

5. Verfahren nach einem der vorangehenden Ansprüche, wobei die auf der passivierten Endoberfläche des Bauteils abgeschiedene Passivierungsschicht eine Haftung von 1,5 bis 3,5 N/cm² zu der Endoberfläche aufweist.

6. Verfahren nach einem der vorangehenden Ansprüche, wobei das kohlenwasserstoffhaltige Monomergas reines Methan ist.

7. Verfahren nach einem der vorangehenden Ansprüche, wobei das kohlenwasserstoffhaltige Monomergas zusammen mit einem Trägergas eingesetzt wird.

8. Verfahren nach einem der vorangehenden Ansprüche, wobei die zur Verlötung vorgesehene Oberfläche in einem reduzierenden Plasmagas entoxidiert wird.

9. Verfahren nach Anspruch 8, wobei das reduzierende Plasmagas Argon, Wasserstoff oder eine Mischung davon ist.

10. Verfahren nach einem der vorangehenden Ansprüche, wobei in dem einzigen Verfahrensschritt der Vorgang der Entoxidation der zur Verlötung vorgesehenen Oberfläche kontinuierlich in den Vorgang der Abscheidung der Passivierungsschicht übergeht.

11. Verfahren nach einem der vorangehenden Ansprüche, wobei die zur Verlötung vorgesehene Oberfläche des Bauteils aus Metall besteht.

12. Verfahren nach einem der Ansprüche 1 bis 10, wobei die zur Verlötung vorgesehene Oberfläche des Bauteils zu wesentlichen Bestandteilen Metall enthält.

13. Verfahren nach einem der vorangehenden Ansprüche, wobei die zur Verlötung vorgesehene Oberfläche des Bauteils eine Leiteroberfläche aus Kupfer ist.

14. Verfahren nach Anspruch 11, wobei das Bauteil eine Leiterplatte ist.

15. Verfahren nach Anspruch 11, wobei das Bauteil ein elektronisches Bauelement ist.

16. Bauteil mit passivierter und lötfähiger Endoberfläche mit einer durch thermische Einwirkung entfernbaren Passivierungsschicht einer Schichtdicke von 15 bis 100 nm, erhältlich durch ein Verfahren nach einem der Ansprüche 1 bis 15.

## Claims

1. Process for the manufacture of a component with a passivated and solderable end surface, wherein in a single process step the surface of the component provided for soldering is cleaned by deoxidation and a passivation layer of monomer gas containing hydrocarbon is deposited onto it in a low-pressure plasma, wherein the deposited passivation layer has a layer thickness of 15 to 100 nm, and wherein the passivation layer deposited on the passivated end surface of the component can be removed again therefrom by thermal action, and a component with a passivated and solderable end surface is obtained as a result thereof.

2. Process according to claim 1, wherein the thermal action is a soldering process.

3. Process according to claim 1 or 2, wherein the temperature during the thermal action amounts to at least 100°C.

4. Process according to one of the preceding claims, wherein the passivation layer deposited on the passivated end surface of the component has a layer thickness of 15 to 50 nm.

5. Process according to one of the preceding claims, wherein the passivation layer deposited on the passivated end surface of the component has an adhesion to the end surface of 1.5 to 3.5 N/cm².

6. Process according to one of the preceding claims, wherein the monomer gas containing hydrocarbon is pure methane.

7. Process according to one of the preceding claims, wherein the monomer gas containing hydrocarbon is used together with a carrier gas.

8. Process according to one of the preceding claims, wherein the surface provided for soldering is deoxidised in a reducing plasma gas.

9. Process according to claim 8, wherein the reducing plasma gas is argon, hydrogen or a mixture thereof.

10. Process according to one of the preceding claims, wherein in the single process step the process of deoxidising the surface provided for soldering merges continuously into the process for depositing the passivation layer.

11. Process according to one of the preceding claims, wherein the surface of the component provided for soldering is made of metal.

12. Process according to one of claims 1 to 10, wherein the surface of the component provided for soldering contains metal in essential parts.

13. Process according to one of the preceding claims, wherein the surface of the component provided for soldering is a copper conductor surface.

14. Process according to claim 11, wherein the component is a circuit board.

15. Process according to claim 11, wherein the component is an electronic component part.

16. Component with passivated and solderable end surface with a passivation layer removable by thermal action with a layer thickness of 15 to 100 nm obtainable by means of a process according to one of claims 1 to 15.

## Revendications

1. Procédé de fabrication d'un composant ayant une surface supérieure terminale, passivée et susceptible d'être soudée, selon lequel au cours d'une unique étape de procédé, on nettoie par désoxydation la surface supérieure du composant prévue pour être soudée et on dépose une couche de passivation dans un gaz monomère contenant des hydrocarbures par un plasma à basse pression,
la couche de passivation déposée ayant une épaisseur de 15 à 100 nm et
la couche de passivation déposée sur la surface supérieure, finale, passivée de la pièce étant de nouveau enlevée par une action thermique pour obtenir un composant ayant une surface terminale passivée et susceptible d'être brasée.

2. Procédé selon la revendication 1, selon lequel l'action thermique est un procédé de brasage.

3. Procédé selon la revendication 1 ou 2, selon lequel la température de l'action thermique est d'au moins 100 °C.

4. Procédé selon l'une des revendications précédentes, selon lequel la couche de passivation déposée sur la surface terminale passivée du composant a une épaisseur de 15 à 50 nm.

5. Procédé selon l'une des revendications précédentes, selon lequel la couche de passivation déposée sur la surface terminale passivée du composant offre un accrochage de 1,5 - 3,5 N/cm² avec la surface terminale.

6. Procédé selon l'une des revendications précédentes, selon lequel le monomère contenant un hydrocarbure est du méthane pur.

7. Procédé selon l'une des revendications précédentes, selon lequel le gaz monomère contenant un hydrocarbure est utilisé en combinaison avec un gaz vecteur.

8. Procédé selon l'une des revendications précédentes, selon lequel la surface prévue pour être brasée est désoxydée dans un gaz de plasma réducteur.

9. Procédé selon la revendication 8, selon lequel le gaz plasma réducteur est de l'argon, de l'hydrogène ou un mélange de ces gaz.

10. Procédé selon l'une des revendications précédentes, selon lequel au cours de l'unique étape de procédé, opération de désoxydation de la surface prévue pour le brasage, passe en continu dans l'opération de dépôt de la couche de passivation.

11. Procédé selon l'une des revendications précédentes, selon lequel la surface de la pièce, prévue pour le brasage est en métal.

12. Procédé selon l'une des revendications 1 à 10, selon lequel la surface de la pièce prévue pour le brasage contient du métal comme composant principal.

13. Procédé selon l'une des revendications précédentes, selon lequel la surface du composent prévu pour le brasage a une surface conductrice en cuivre.

14. Procédé selon la revendication 11, selon lequel le composant est une plaque de circuit.

15. Procédé selon la revendication 11, selon lequel le composant est un composant électronique.

16. Composant à surface terminale passivée et susceptible d'être brasée comportant une couche de passivation qui peut être enlevée par effet thermique et a une épaisseur de 15 à 100 nm obtenue par un procédé selon l'une des revendications 1 à 15.
